Europäisches Patentamt

European Patent Office

Office européen des brevets

(11) Publication number: 0 495 215 A2

# EUROPEAN PATENT APPLICATION

(21) Application number: 91121620.8

(51) Int. Cl.⁵: **C23C 14/22**, C23C 14/24

(22) Date of filing: 17.12.91

(30) Priority: **16.01.91 JP 3425/91**

(43) Date of publication of application:
**22.07.92 Bulletin 92/30**

(84) Designated Contracting States:
**DE FR GB**

(71) Applicant: **KABUSHIKI KAISHA KOBE SEIKO SHO also known as Kobe Steel Ltd.**
**3-18 1-chome, Wakinohama-cho Chuo-ku**
**Kobe 651(JP)**

(72) Inventor: **Tsuji, Kunihiko**
**11-2, 2-chome, Shioya-kitamachi**
**Tarumi-ku, Kobe-shi(JP)**

(74) Representative: **Tiedtke, Harro, Dipl.-Ing. et al**
**Patentanwälte Tiedtke-Bühling- Kinne &**
**Partner Bavariaring 4 POB 20 24 03**
**W-8000 München 2(DE)**

(54) Vapor deposition device.

(57) A vapor deposition device comprising a vacuum vessel, an evaporation source disposed in the vacuum vessel, a plurality of evaporation materials disposed around the evaporation source, and an evaporation source rotating means for rotating the evaporation source such that the evaporation materials are brought into a working position one by one while holding remaining evaporation materials at shielded positions. Working efficiency upon coating can be improved and a plurality layers of coating can be applied in one step of processing.

FIG. I

## BACKGROUND OF THE INVENTION

Field of the Invention

The present invention relates to a vapor deposition device having a rotary evaporation source.

Description of the Prior Art

A vapor deposition device used for an arc ion plating device, sputtering device and the like has been disclosed, for example, in Japanese Patent Publication Sho 58-3033.

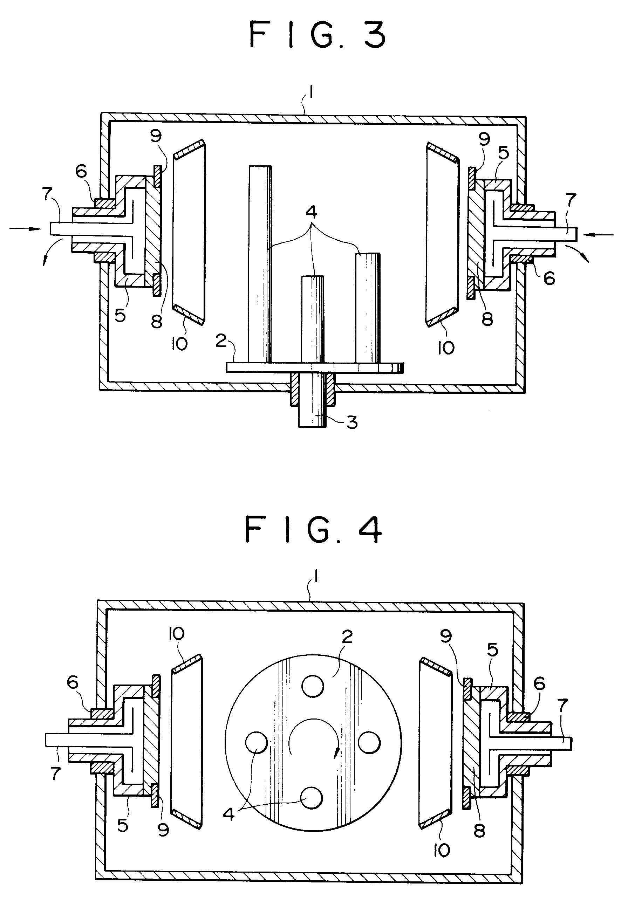

Referring to a conventional vapor deposition device used for an arc ion plating device, it is constituted as shown in Figs. 3 and 4, wherein a rotary table 2 is rotatably supported around a vertical shaft 3 in a vacuum vessel 1, and is rotated by a driving device (not illustrated). Reference numeral 4 denotes materials 4 to be coated. One or more pairs of arc evaporation sources 5 are disposed in the vacuum vessel 1 so as to oppose to the materials 4 to be coated and electrically insulated relative to the vacuum vessel 1 by an insulator 6. A cooling water channel 7 is disposed in the arc evaporation source 5. An evaporation material 8 is detachably disposed on the front face of the arc evaporation source 5 by means of a retainer frame 9. Reference numeral 10 denotes an anode.

The arc evaporation source 5 is usually attached to the side wall of the vacuum vessel 1, to which a vacuum pump and a supply system for a gas required for the process (not illustrated) are connected. The materials 4 to be coated are placed on the rotary table 2 and applied with coating under rotation together with the rotary table 2, to form a deposition film of a uniform thickness on the periphery thereof. The kind of the deposition film is determined by the combination of the evaporation material 8 and a reaction gas to be introduced into the vacuum vessel 1. For instance, when the evaporation material 8 is titanium and the reaction gas is nitrogen, titanium nitride (TiN) is formed on the periphery of the material 4 to be coated. Upon coating, the evaporation material 8 is attached to the arc evaporation source 5, and vacuum arc discharge is started by an ignition device while setting the pressure inside the vacuum vessel 1 at $1 \times 10^{-1}$ Torr or less. The evaporation material is then evaporated to form a film on the surface of the materials to be coated.

In the prior art device, when thew kind of the deposition film is intended to be changed, the vacuum vessel 1 is open to perform the replacement of the evaporation materials 8 Consequently, the device has to be stopped during the replacement, and therefore, the processing efficiency is poor. Further, in coating a composite layer film comprising two or more kinds of materials in one stop of processing, it is necessary to previously provide a plurality of arc evaporation sources 5 having required kinds of evaporation materials 8, which makes the installation cost expensive. Further, the surface of one of the evaporation materials 8 is deposited with the other evaporation materials of the other arc evaporation sources 5, to thus cause contamination.

## SUMMARY OF THE INVENTION

It is therefore an object of the present invention to improve the processing efficiency, and enable coating of a composite layer in one step of processing, and further prevent contamination of an evaporation material caused by deposition of other materials.

According to the present invention, there is provided a vapor deposition device comprising an evaporation source having evaporation materials in a vacuum vessel, wherein an evaporation source is rotatably supported around a rotational shaft, and a plurality of evaporation materials are disposed on the periphery of the evaporation source so as not to oppose to each other, so that when one of a plurality of evaporation materials is situated at a working position, remaining evaporation materials are situated at shielded positions.

More specifically, an evaporation source 14 is rotated around a rotational shaft 16 and a required one of evaporation materials 19 is set at a working position to execute the coating treatment under such a state.

Accordingly, if it is necessary to frequently replace the evaporation materials 19 in a single layer coating, they can be replaced by merely rotating the evaporation source 14. Further, by the rotation of the evaporation source 14, a composite layer coating can be executed in one step of processing.

## BRIEF DESCRIPTION OF THE DRAWINGS

Fig. 1 is a front cross sectional view illustrating a preferred embodiment according to the present invention;

Fig. 2 is a plan cross sectional view illustrating a preferred embodiment according to the present invention;

Fig. 3 is a front cross sectional view illustrating an embodiment of the prior art; and

Fig. 4 is a plan cross sectional view illustrating the embodiment of the prior art.

## DETAILED DESCRIPTION OF THE PREFERRED EMBODIMENTS

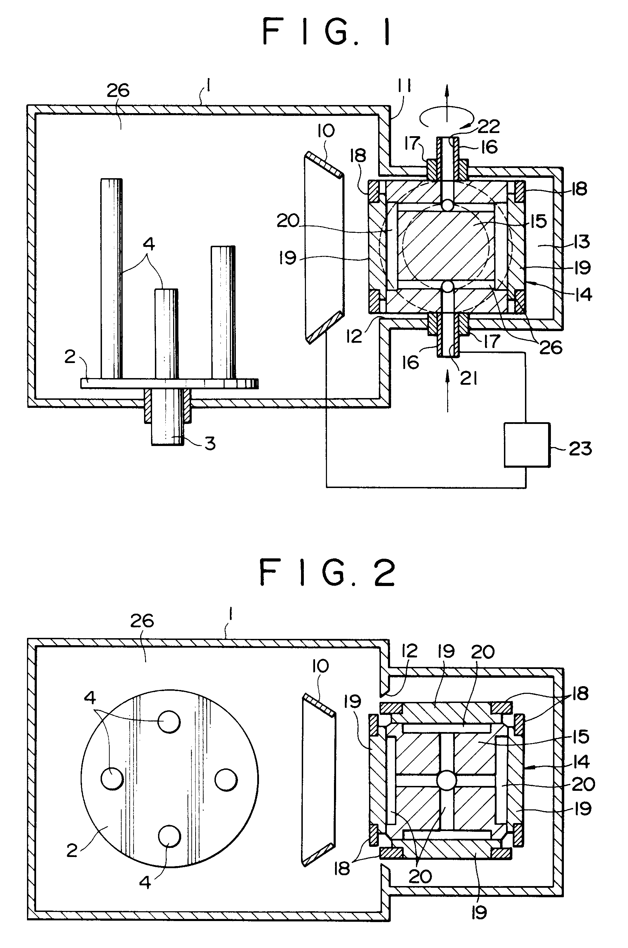

A preferred embodiment of the present invention will now be described more in details with reference to the drawings. Figs. 1 and 2 show a case of applying the present invention to an arc ion plating device. As shown in Figs. 1 and 2, a vapor deposition chamber 26 containing materials 4 to be coated has an evaporation source containing chamber 13 protruded outward, which is in communication with the inside of the vapor deposition chamber 26 through a window hole of one side wall 11. The arc evaporation source 14 is contained in the containing chamber 13. The vapor deposition chamber 26 and the evaporation source containing chamber 13 constitute a vacuum vessel 1.

The arc evaporation source 14 has in its inside a cubic evaporation source main body 15 connected to a pair of rotational shafts 16 disposed on both upper and lower ends and is attached rotatably to upper and lower walls of the containing chamber 13 through the rotational shafts 16 and the insulators 17. The evaporation source main body 15 has four mounting surfaces therearound, to each of which the evaporation material 19 is detachably mounted through a mounting frame 13. The evaporation source main body 15 can be driven rotationally by a rotational mechanism (not illustrated), so that one of four evaporation materials 19 situates at the working position on the side of the window hole 12 in the vacuum vessel 1. The evaporation materials 19 are mounted separately on four mounting surfaces of the evaporation source main body 15 so as not to oppose to each other and consequently, when one of evaporation materials 19 situates at the working position, other three evaporation materials 19 situate on the shielded sides.

The evaporation source main body 15 has a cooling water channel 20 therein so as to cool each of the evaporation materials 19 at the back. Cooling water is supplied to the cooling water channel 20 through a channel 21 formed in the lower rotational shaft 16 and discharged to the outside through a channel 22 formed in the upper rotational shaft 16.

The arc evaporation source 14 is connected through the rotational shafts 16 to an arc power source 23, and an ignition mechanism (not illustrated) identical with the conventional one.

When coating is applied to the material 4 to be coated with the constitution as described above, the arc evaporation source 14 is rotated around the rotational shaft 16 to set a required one of four evaporation materials 19 at a working position and an arc current is supplied from the arc power source 23.

In this case, if the coating is applied for the single layer coating in which the evaporation materials 19 have to be replaced frequently, the arc evaporation source 14 is previously attached with predetermined kinds of evaporation materials 19 and is rotated, to thereby replace the evaporation materials 19 successively. Accordingly, the recess time is scarcely required for replacing the evaporation materials 19 to remarkably improve the working efficiency.

In addition, a plurality of coating treatments can be applied in one step of processing. In this case, the arc evaporation source 14 is rotated around the rotational shaft 16 and the four evaporation materials 19 at the outer circumference of the arc evaporation source 14 are set successively to the working position, and arc is generated on every evaporation materials 19 respectively to apply coating. Accordingly, a composite layer coating comprising up to four layers can be applied in this embodiment.

During coating by one evaporation material 19, since other evaporation materials 19 under stand-by are situated at shielded positions, they do not deposit to the evaporation material 19 during evaporation. Therefore, although the arc evaporation source 14 contains the four evaporation materials 19, the evaporation material 19 during evaporation by the deposition of other stand-by materials can be prevented.

In this embodiment, four (four kinds) of evaporation materials 19 are attached to the outer circumference of the arc evaporation source 14, but the evaporation source main body 15 may be in a hexagonal or octagonal configuration so that six or eight kinds of evaporation materials 19 can be attached.

In a case where the arc evaporation source 14 is rotated only with an aim for saving the trouble of replacing the evaporation materials, it may be rotated by a rotational mechanism disposed at the inside of the containing chamber 13, in addition to the rotation by the external rotational mechanism.

The present invention is also applicable as a sputtering device by replacing the arc power source 23 with a sputtering power source.

According to the present invention, since the evaporation source is rotatably supported by the rotational shaft and a plurality of evaporation materials are attached around the evaporation source so as not to opposed to each other, so that when one of a Plurality of the evaporation materials is at a working position, remaining evaporation materials are at shielded positions, the processing efficiency can be improved as compared with the prior art, a composite layer coating can be executed in one step of processing, as well as contamination of the evaporation material during evaporation by the deposition of other stand-by materials can be prevented.

A vapor deposition device comprising a vacuum vessel, an evaporation source disposed in the vacuum vessel, a plurality of evaporation materials disposed around the evaporation source, and an evaporation source rotating means for rotating the evaporation source such that the evaporation materials are brought into a working position one by one while holding remaining evaporation materials at shielded positions. Working efficiency upon coating can be improved and a plurality layers of coating can be applied in one step of processing.

**Claims**

1. A vacuum vapor deposition device comprising:
   (a) a vacuum vessel,
   (b) an evaporation source disposed in said vacuum vessel,
   (c) a plurality of evaporation materials disposed around said evaporation source, and
   (d) an evaporation source rotating means for rotating said evaporation source such that when one of the evaporation materials situates at a working position remaining evaporation materials situate at shielded positions.

2. A vacuum vapor deposition device as defined in claim 1, wherein the vapor deposition device is a sputtering device.

3. A vacuum vapor deposition device as defined in claim 1, wherein the vapor deposition device is an arc ion plating device.

4. A vacuum vapor deposition device as defined in claim 3, wherein four kinds of evaporation materials are used.

5. A vacuum vapor deposition device as defined in claim 3, wherein six kinds of evaporation materials are used.

6. A vacuum vapor deposition device as defined in claim 3, wherein eight kinds of evaporation materials are used.

7. A vacuum vapor deposition device as defined in claim 3, wherein the vacuum vessel comprises a vapor deposition chamber for containing a material to be coated and an evaporation source containing chamber for containing the evaporation source.

8. A vacuum vapor deposition device as defined in claim 7, wherein the evaporation source containing chamber is in communication with the vapor deposition chamber through a window hole formed on one side wall of said deposition chamber and is protruded outside the vapor deposition chamber.

9. A vacuum vapor deposition device as defined in claim 7, wherein the evaporation source is rotatable relative to the upper and lower walls of the evaporation source containing chamber.

10. A vacuum vapor deposition device as defined in claim 7, wherein the evaporation source comprises, at its inside, an evaporation source main body having a rotational shafts connected to both upper and lower ends thereof

11. A vacuum vapor deposition device as defined in claim 10, wherein the evaporation source main body is shaped like a cube.

12. A vacuum vapor deposition device as defined in claim 10, wherein a cooling water channel is formed to the evaporation source main body so as to cool each of the evaporation materials from the back thereof.

13. A vacuum vapor deposition device as defined in claim 12, wherein the cooling water channel supplies cooling water through a channel formed in the lower rotational shaft and discharges cooling water to the outside through a channel formed in the upper rotational shaft.

14. A method for applying vacuum vapor deposition by using a plurality of evaporation materials disposed in a vacuum vessel, wherein when one of evaporation materials situates at a working position, remaining evaporation materials are held at shielded positions, and one of evaporation materials situated at the working position is replaced, after consumption, with other evaporation material which is identical with the consumed material and situated at the shielded position by rotating the evaporation materials.

15. A method for applying vacuum vapor deposition by using a plurality of evaporation materials disposed in a vacuum vessel, wherein when one of evaporation materials situates at a working position remaining evaporation materials are held at shielded positions, and one of evaporation materials situated at the working position is replaced, after consumption, with other evaporation material which is different from the consumed material and situated at the shielded position by rotating the evaporation materials.

# F I G. 1

# F I G. 2

5

# F I G. 3

# F I G. 4